# EUROPEAN PATENT APPLICATION

(11) **EP 0 544 398 A1**
(43) Date of publication of application: **02.06.1993**
(21) Application number: 92309309.0
(22) Date of filing: 13.10.1992
(51) Int. Cl.: B23K 26/00

(54) **An apparatus for laser processing of composite structures**

(30) Priority: 15.10.1991 GB 9122010
(71) Applicant: BRITISH AEROSPACE PUBLIC LIMITED COMPANY, Farnborough, Hants. GU14 6YU (GB)
(72) Inventor: Williams, Stewart Wynn, British Aerospace plc, Bristol BS12 7QW (GB); Scott, Graeme, British Aerospace plc, Bristol BS12 7QW (GB)
(74) Representative: Rooney, Paul Blaise

(57) **Abstract**

An apparatus for laser processing of composite structures comprises a first and second laser (10, 12) for producing first and second laser beams (11, 17) suitable for processing first and second materials (4, 6) of a composite structure (2), a detection means (16) for detecting which material is exposed for processing and a switching means for automatic switching of one or more of the lasers on or off as the case may be depending upon which material is exposed for processing.

## Description

The present invention relates to an apparatus for laser processing of composite structures and relates particularly, but not exclusively, to such an apparatus suitable for use in cutting, drilling or marking layered composite structures.

Layered composite structures can comprise alternate layers of metal and fibre reinforced composite material all bonded together to form a structure of great strength. The composite layers are commonly composed of either glass fibre reinforced composite (GLARE) or aramidic fibre reinforced composite (ARAL), whilst the metal layers are commonly made from aluminium alloy. Processing the layered composite structure, which can comprise the steps of cutting and or drilling etc., is complicated by the fact that the structure is formed from two dissimilar materials. Methods of processing the metal layers such as milling or the use of abrasive water jets do not lend themselves to the processing of the composite layers where they can cause delamination of the composite layers, pulling and shredding of the fibres and poor finish. Thermal techniques include the use of Infra Red or plasma torches etc. Accurate processing of composite structures with thermal techniques lasers is difficult because the temperatures required to vaporise the various layers are very different. This means that charring and buming of the fibre reinforced composite layer can occur and removal of matrix material from the edge of the cut can be made worse due to the high thermal conductivity of the metal layers. Ultra Violet lasers, whilst being perfectly adequate for processing fibre reinforced composite layers are unable to process metal layers quickly enough, due to the nature of their interaction and their relatively low power.

It is an object of the present invention to provide an apparatus for laser processing of layered composite structures which overcomes the problems associated with the above mentioned methods.

Accordingly, the present invention provides an apparatus for laser processing layered composite structures characterised in that the apparatus comprises a first laser for the production of a first laser beam suitable for processing a first material of a composite structure,
a second laser for the production of a second laser beam suitable for processing a second material of the composite structure,
first switching means for switching said first laser on when said first material is exposed for processing and for switching said first laser off when said second material is exposed for processing,
and detection means for detecting which of said materials is exposed for processing, said detection means being linked to the switching means for automatic switching on or off of said first laser as required.

It will be appreciated that by providing a laser suitable for machining each material in the composite structure, a switching means and a detection means it will be possible to automatically switch the first laser off whenever its use could cause damage to the second material of the composite structure and turn it on whenever its use would assist in the processing of the first material.

Preferably, the apparatus includes a second switching means for switching said second laser on when said second material is exposed for processing and for switching said second laser off when said first material is exposed for processing. This arrangement has the advantage of allowing the second laser to be turned off whenever it is not required thus reducing the overall power consumption of the apparatus.

In a particularly advantageous arrangement, the apparatus includes a projection means for projecting a detection beam of light onto the surface of the material exposed for processing and in which the detection means is configured to detect the quantity of detection beam light reflected off the surface of the material exposed for processing and to compare it with predetermined values for each of said materials, thereby to determine which of said materials is exposed for processing.

Conveniently the projection means may comprise the second laser itself together with means for focusing the detection beam onto the surface of the material to be processed.

Alternatively the projection means may comprise a visible or near visible india red detection laser or similar source for producing said detection beam and means for focusing the detection beam onto the surface of the material to be processed.

Advantageously, a filter means is provided whenever it is desirable to prevent any laser beam light from the first or second lasers entering the detection means.

A beam combiner may be provided for combining the second laser beam and the detection beam prior to said beams impinging on the first or second material. The beam combiner may be transparent to the second laser beam and reflective of said detection beam.

First and second beam directing means and first and second beam focusing means may be provided for directing and focusing the first and second laser beams onto the material exposed for processing.

Conveniently, the second beam directing means and shaping means are positioned for receiving the second laser beam after it has been combined with the detection beam, thereby to direct and focus the combined beam onto the material exposed for processing.

Advantageously, the first laser, second laser and the projection means are each positioned for projecting the first laser beam, the second laser beam and the detection beam onto a common point on the surface of the material exposed for processing.

Preferably, the first laser comprises an Infra Red laser suitable for processing metal and the second laser comprises an Ultra Violet laser suitable for processing fibre reinforced composite material.

In an alternative arrangement the detection means includes a method such as radiometry for determining the temperature rises in the materials exposed for machining due to the action of the lasers.

Conveniently, the apparatus includes a fibre optic delivery system for delivering the first laser beam or the second laser beam or the detection beam.

The present invention will now be more particularly described by way of example only with reference to the accompanying drawings in which:
Figure 1 is a cross-sectional view of a typical composite structure, and
Figure 2 is a diagrammatic representation of an apparatus acceding to the present invention.

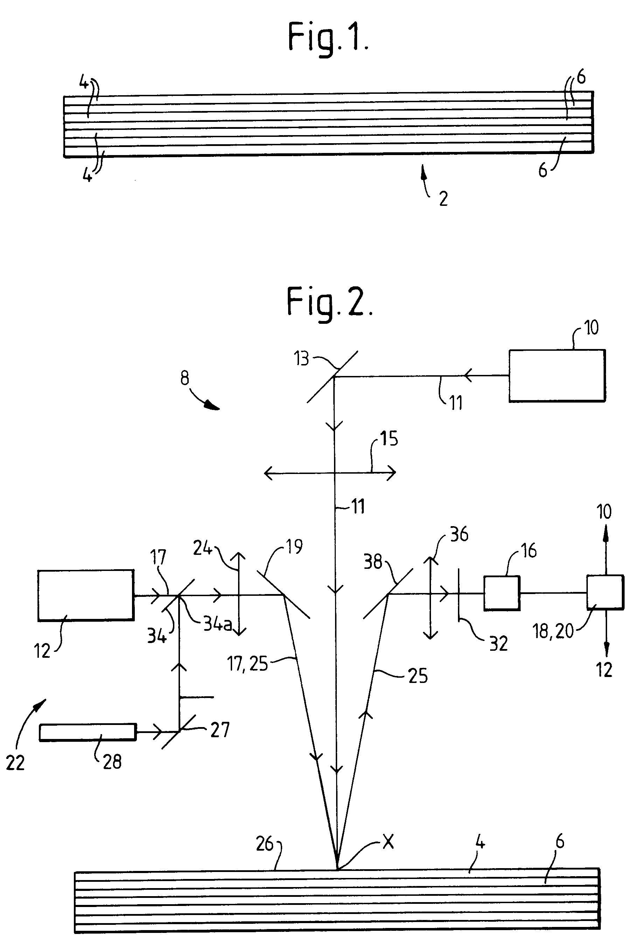

Referring briefly to figure 1, layered composite structures (2) can comprise alternate layers of metal (4) and fibre reinforced composite material (6) all bonded together to form a structure of great strength. The composite layers are commonly composed of either glass fibre reinforced composite (GLARE ) or aromidic fibre reinforced composite (ARAL) whilst the metal layers (4) are commonly made of aluminium alloy.

Figure 2 illustrates an apparatus (8) for laser processing of composite structures. The apparatus comprises a first comparatively high powered laser (10) of the CO₂ type for producing a first laser beam (11) suitable for processing the first metal material (4) of a composite structure (2) and a second laser (12) of the Ultra Violet type, for producing a second laser beam (17) suitable for processing the second composite layer.

The first laser (10) produces a first laser beam (11) which is directed towards the material to be processed by a directing means in the form of a mirror (13) and focused onto the surface thereof by lens (15). The second laser (12) produces a second laser beam (17) and is similarly provided with a directing mirror (19) and lens (24). A detection means (16) is provided for detecting which of said first or second materials is exposed for processing and is linked to at least a first switching means (18) for switching the first laser (10) on when the first metal material is exposed for processing and off when the second material is exposed for processing. In this arrangement, the second Ultra Violet laser (12) is operated continuously and the first laser is only switched on when the metal layer is exposed for processing, thus preventing the first laser damaging the composite layer whenever it is exposed for processing. It will be appreciated that due to its comparatively low power, the second laser can be operated continuously without damaging the metal layer and its continuous use can in fact contribute to the machining rate achieved by the first comparatively high power laser (10).

A second switching means (20) may be provided for switching the second laser (12) on when the second material is exposed for processing and for switching it off when the first material is exposed for processing.

A projection means shown generally at (22) is provided for projecting a detection beam of light (25) onto the surface (26) of the material exposed for processing. The projection means may comprise the second laser (12) itself and means (24) for focusing a detection beam (25) onto the surface (26) or it may comprise a separate visible or near visible infra red detection laser (28) or some such similar source and said focusing means. The detection means (16) is configured to detect the quantity of detection beam light reflected off the surface (26) and to compare it with predetermined values for each of the materials to be processed, thereby to determine which of said materials is exposed for processing. It will be appreciated that when the second laser (12) is used as the projection means it will be left on throughout the processing operation in order to provide the detection beam (25) required for material identification. However, whenever a separate projection means (28) is provided the second laser (12) may be turned off whenever it is not required, thus reducing the overall power consumption of the apparatus (8).

When a separate projection means (28) is provided a filter (32) is also provided for preventing any laser beam light from the first or second lasers (10, 12) entering the detection means (16) as this could adversely affect the operation of the detection means. A beam combiner (34) may be provided in order to combine the second laser beam (17) with the detection beam (25) when required. The beam combiner may be transparent to said second laser beam (17) and reflective of the detection beam (25) in which case it may be positioned such that the beams (17, 25) are combined when passed through or reflected from a surface (34a) thereof as the case may be. The beam combiner is preferably positioned to combine the beams before they are passed to the lens (24) and directing mirror (19) thereby to ensure both beams are co-incident and directed onto the same point on the material exposed for processing. Clearly, the best indication of which material is being processed is obtained when the first laser, second laser, and the detecting beams are all directed onto a common point (X) on the surface of the material exposed for processing. After reflection off the surface (26), the detection beam (25) is collected by a lens (36) and passed through filter (32) prior to entering the detector (16). A mirror (38) may be provided for directing the reflected detection beam to the lens (36). In an alternative arrangement, the detection means (30) may comprise means for determining the temperature rises in the materials due to the action of the lasers either at the processing point or at a point adjacent thereto.

In operation, a processing operation is commenced by firstly switching on the projection means (22) and detector means (16). This allows the detector means (16) to identify which of the two materials (4,6) is exposed for processing. Automatic switching on of the required lasers (10, 12) is then achieved via switching means (18. 20) and processing is commenced. The detector means (16) constantly monitors the quantity of reflected detection beam light and compares it with predetermined values for each of the materials to be processed, thereby to determine which of said materials is exposed for processing. Upon detection of a change in material being processed the switching means automatically switches the appropriate laser on and switches the other laser off if required. The automatic switching is continued throughout the processing operation until all the layers of the composite structure have been processed. Processing could include drilling, cutting or marking as required.

## Claims

1. An apparatus (8) for laser processing layered composite structures (2), characterised in that the apparatus comprises:
a first laser (10) for the production of a first laser beam (11) suitable for processing a first material (4) of a composite structure (2),
a second laser (12), for the production of a second laser beam (17) suitable for processing a second material (6) of the composite structure (2),
first switching means (18) for switching said first laser (10) on when said first material (4) is exposed for processing and for switching said first laser (10) off when said second material (6) is exposed for processing, and
detection means (16) for detecting which of said materials (4, 6) is exposed for processing, said detection means (16) being linked to the switching means (18) for automatic switching on or off of said first laser (10) as required.

2. An apparatus (8) as claimed in claim 1 including a second switching means (20) for switching said second laser (12) on when said second material (6) is exposed for processing and for switching said second laser (12) off when said first material (4) is exposed for processing.

3. An apparatus (8) as claimed in claim 1 or claim 2 including projection means (22) for projecting a detection beam of light (25) onto the surface (26) of the material exposed for processing and in which the detection (22) means is configured to detect the quantity of detection beam light (25) reflected off the surface of the material exposed for processing and to compare it with predetermined values for each of said materials, thereby to determine which of said materials (4, 6) is exposed for processing.

4. An apparatus as claimed in claim 3 in which the projection means (22) comprises the second laser (12) and means (24) for focusing the detection beam (25 onto the surface (26) of the material to be processed.

5. An apparatus as claimed in claim 3 in which the projection means (22) comprises a visible or near visible infra red detection laser (28) for producing said detection beam and means (24) for focusing the detection beam (25) onto the surface of the material to be processed.

6. An apparatus as claimed in claim 5 including filter means (32) for preventing any laser beam light from the first or second lasers entering the detection means (16).

7. An apparatus as claimed in claim 5 or 6 including a beam combiner (34) for combining the second laser beam (17) and the detection beam (25) prior to said beams impinging on said first or second material (4, 6).

8. An apparatus as claimed in claim 7 in which the beam combiner (34) is transparent to said second laser beam (17) and reflective of said detection beam (25).

9. An apparatus as claimed in any one of claims 1 to 8 including first beam directing means (13) for directing the laser beam from the first laser and first beam shaping means (15) for focusing the first laser beam (11) onto the material to be processed (4, 6).

10. An apparatus as claimed in any one of claims 3 to 9 including second beam directing means (19) for directing the laser beam from the second laser and second beam shaping means (24) for focusing the second laser beam (17) onto the material exposed for processing (4, 6).

11. An apparatus as claimed in claim 10 in which the second beam directing means (19) and second beam shaping means (24) are positioned for receiving said second laser beam (17) after it has been combined with the detection beam (25), thereby to direct and focus the combined beam onto the material exposed for processing (4, 6).

12. An apparatus as claimed in any one of claims 3 to 11 in which the first laser (10), second laser (12) and the projection means (28) are positioned for projecting the first laser beam (11), the second laser beam (17) and the detection beam (25) onto a common point (X) on the surface of the material exposed for processing.

13. An apparatus as claimed in any one of claims 1 to 12 in which the first laser (10) comprises an Infra Red laser suitable for processing metal.

14. An apparatus as claimed in any one of claims 1 to 13 in which the second laser (12) comprises an Ultra Violet laser suitable for processing fibre reinforced composite material.

15. An apparatus as claimed in claim 1 or 2 in which the detection means (16) includes means for determining the temperature rises in the materials exposed for machining due to the action of the lasers (10, 12).

16. An apparatus as claimed in any one of the preceding claims including a fibre optic delivery system for delivering the first laser beam (11) or the second laser beam (17) or the detection beam (25).
